# EUROPEAN PATENT APPLICATION

(11) **EP 4 471 175 A1**
(43) Date of publication of application: **04.12.2024**
(21) Application number: 24158264.2
(22) Date of filing: 19.02.2024
(51) Int. Cl.: C23C 14/32, A44C 27/00, C23C 14/18, G04B 37/22, C23C 28/00, G04B 45/00, C23C 14/02, C23C 14/06, C23C 14/00

(54) **ORNAMENT SURFACE PROCESSING TREATMENT METHOD AND STRUCTURE THEREOF**

(30) Priority: 12.05.2023 TW 112117729
(71) Applicant: Inpark International Limited, New Taipei City 234 (TW)
(72) Inventor: Peng, Wei-Cheng, New Taipei City (TW)
(74) Representative: Horak, Michael

(57) **Abstract**

On a surface of a stainless-steel metallic base material (1), ion bombardment processing, sputter deposition processing, and arc deposition processing are applied in sequence, and each parameter of the processing is severely controlled. The ion bombardment removes oxides from the surface of the stainless-steel metallic base material (1) to expose a plurality of base-material cavity portions (11) in order to help reduce surface roughness in the subsequent processing of deposition. The sputter deposition deposits color nitride ions on the surface of the stainless-steel metallic base material (1) and in the base-material cavity portions (11) to make the base material color lighter and to increase base material rigidity to 1800HV to 2000HV. The arc deposition sequentially deposits first and second color metal ions (3, 4) on a surface of the color nitride ions (2) to have final roughness reduced to 0.01µm to 0.1µm and final LAB values of color parameters forming a configuration closest to 18K gold.

## Description

### TECHNICAL FIELD OF THE INVENTION

The present invention provides an ornament surface processing treatment method that controls various process parameters to form high rigidity, low surface roughness, and a color that is closest to 18K gold on a surface of an ornament, and a structure thereof.

### DESCRIPTION OF THE PRIOR ART

The general consumers' buying desire is often enhanced by futuristic designs. And, adopting designs of color to suit the consumers' desire for aesthetics is very often found in marking of brand ornaments.

Tri-color golds, which are precious metals, are commonly used in making ornaments themselves or setting metals for jewelry, and are generally classified by colors to white gold of silver color, yellow gold of gold color, and rose gold of pink color. The primary component of these three golds is gold, and the color difference primarily results from the alloy ratios thereof with respect to other metals. Metals of this kind are generally of a very high prices, and are thus referred to as precious metals.

It is available in the market to coat a layer of gold color on an ordinary metal by applying the vacuum coating technology, and such a gold color is claimed to be exhibiting a color of gold but using no precious metal, so that a gold-colored surface may be formed while the cost is reduced. However, such a way of gold-like coating shows brightness, surface roughness, and rigidity that are barely satisfactory, while exhibiting the following defects:
(1) Although such a color is claimed to be gold color, a comparison with gold clearly exhibits a difference that can be identified by bare eyes, and as such, it is generally impossible to make a 18K gold color that involves no precious metal at all.
(2) In forming a coating by means of sputtering coating, the deposition rate is generally very low due to a bombardment surface being of a small area, and ion beam sputter deposition is not suitable for depositing a large-area film of uniform thickness, so that coating a metallic film by means of sputtering coating may suffer a relatively low thickness or rigidity.
(3) In forming a coating by means of arc deposition, if a surface of a raw material is not sufficiently smooth, attachment of microparticles thereto in the process of deposition may be not uniform and this may easily result in a rough surface, and further, although such a process is capable of color adjustment and regulation, yet if the base material has a very dark color, the period of time for deposition would be extended, and the amount of target materials consumed would be relatively large.

### SUMMARY OF THE INVENTION

The primary objective of the present invention is to conduct, with respect to bombardment processing, sputter deposition processing, and arc deposition processing, separate control over processing parameters in order to reduce final surface roughness to 0.01 µm -0.1 µm and make final LAB-values of color parameters forming a configuration closest to 18K gold, so that a luxurious metallic fashion can be made without using precious metals.

The main structure of the present invention includes: a stainless-steel metallic base material, a plurality of base-material cavity portions formed in the stainless-steel metallic base material, a plurality of color nitride ions disposed in the base-material cavity portions and on a surface of the stainless-steel metallic base material, a plurality of first color metal ions disposed on a surface of the color nitride ions, and a plurality of second color metal ions disposed on a surface of the first color metal ions.

To carry out processing, a stainless-steel metallic base material is first selected, and the stainless-steel metallic base material is subjected to ion bombardment to remove oxides from a surface of the stainless-steel metallic base material in order to expose a plurality of base-material cavity portions to help reduce surface roughness in subsequent processing of deposition to 0.01µm to 0.1µm, and next, the stainless-steel metallic base material is subjected to sputter deposition to implant color nitride ions into the base-material cavity portions and the surface of the stainless-steel metallic base material to make a color of the base material lighter and to increase rigidity of the base material to 1800HV to 2000HV, and finally, the stainless-steel metallic base material is subjected to arc deposition to form first color metal ions on a surface of the color nitride ions and form second color metal ions on the first color metal ions. In this case, a non-precious metal is selected as a target material, and plasma is used to control the color to LAB-value color parameters (L being 72 to 93, A being 2.5 to 8, and B being15 to 35) to be closest to 18K gold. In the above, the processing parameters of the ion bombardment include: applying a gas pressure at a value of 0 Torr to -1 Torr to control an environment gas pressure to -1 Torr, an environment temperature of 200°C to 300°C, a voltage of 300kV to 400kV, an energy density of 106W/cm² to 109W/cm², a power density of 105W/cm² to 1011W/cm², and keeping for a time of 200 seconds to 400 seconds; the processing parameters of the sputter deposition include: applying a gas pressure at a value of 1 Torr to -1 Torr to control an environment gas pressure to -2 Torr, an environment temperature of 150°C to 400°C, a voltage of 350kV to 400kV and keeping for a time of 550 seconds to 1000 seconds; and the processing parameters of the arc deposition include: applying a gas pressure at a value of 1 Torr to -1 Torr to control an environment gas pressure to -3 Torr, an environment temperature of 125°C to 300°C, a voltage of 500kV to 550kV, a current intensity of 400A to 430A, a current density of 106A/cm² to 1012A/cm², an arc voltage of 10V to 40V, an arc moving speed of 90m/s to 110m/s, an instantaneous discharging time of 10ns to 1000ns, and keeping for a time of 200 seconds to 400 seconds.

### BRIEF DESCRIPTION OF THE DRAWINGS

FIG. 1 is a flow chart showing steps of a first embodiment of the present invention.
FIG. 2 is a perspective view showing the first embodiment of the present invention.
FIG. 3 is a schematic view showing a structure of the first embodiment of the present invention.
FIG. 4 is a schematic view showing ion bombardment for the first embodiment of the present invention.
FIG. 5 is a schematic view showing sputter deposition for the first embodiment of the present invention.
FIG. 6 is a schematic view showing arc deposition for the first embodiment of the present invention.
FIG. 7 is a flow chart showing steps of a second embodiment of the present invention.

### DETAILED DESCRIPTION OF THE PREFERRED EMBODIMENT

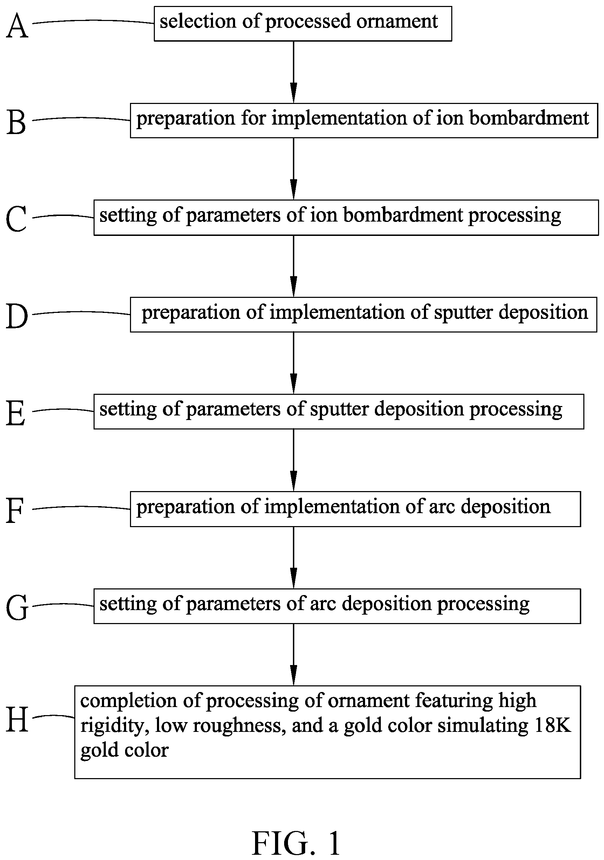

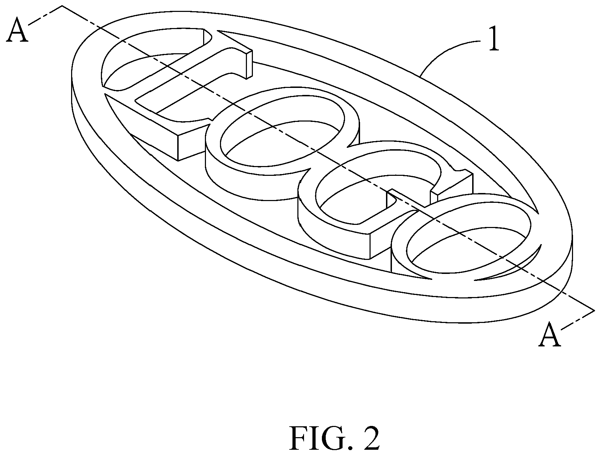

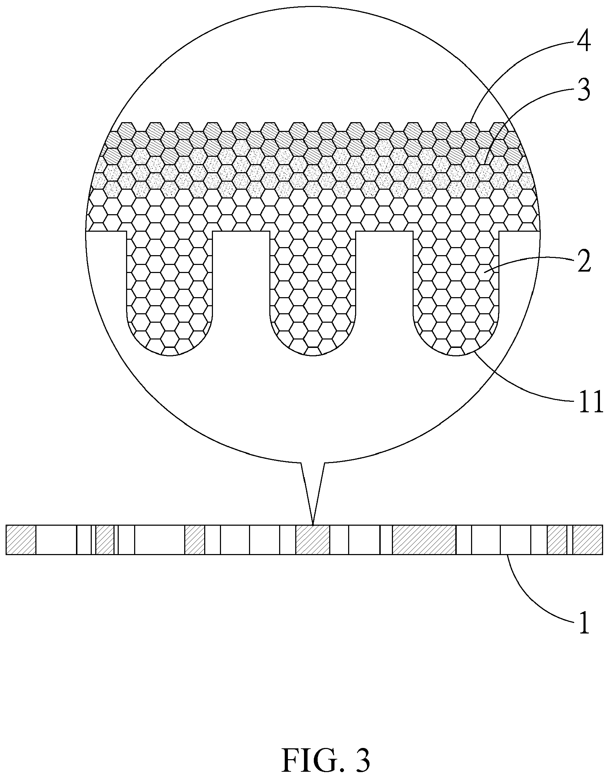

As s shown in FIGS. 1-3, it is seen from the drawings that main steps of the present invention comprise:
(A) selection of processed ornament: selecting a stainless-steel metallic base material 1;
(B) preparation for implementation of ion bombardment: subjecting the stainless-steel metallic base material 1 to ion bombardment to remove oxides on a surface of the stainless-steel metallic base material 1 so as to expose a plurality of base-material cavity portions 11;
(C) setting of parameters of ion bombardment processing: applying a gas pressure at a value of 0 Torr to -1 Torr to control a processing environment gas pressure of the ion bombardment to -1 Torr and control a processing environment temperature of the ion bombardment to 200°C to 300°C, and control a voltage of the ion bombardment to 300kV to 400kV, an energy density being 106W/cm² to 109W/cm², and a power density being 105W/cm² to 1011W/cm², and keeping for 200 seconds to 400 seconds;
(D) preparation of implementation of sputter deposition: subjecting the stainless-steel metallic base material 1 to sputter deposition so as to implant color nitride ions 2 into the base-material cavity portions 11 and the surface of the stainless-steel metallic base material 1;
(E) setting of parameters of sputter deposition processing: applying a gas pressure at a value of 1 Torr to -1 Torr to control a processing environment gas pressure of the sputter deposition to -2 Torr, and control a processing environment temperature of the sputter deposition to 150°C to 400°C, and control a voltage of the sputter deposition to 350kV to 400kV, and keeping for 550 seconds to 1000 seconds;
(F) preparation of implementation of arc deposition: subjecting the stainless-steel metallic base material 1 to arc deposition so as to form first color metal ions 3 on a surface of the color nitride ions 2 and to further form second color metal ions 4 on a surface of the first color metal ions 3;
(G) setting of parameters of arc deposition processing: applying a gas pressure at a value of 1 Torr to -1 Torr to control a processing environment gas pressure of the arc deposition to -3 Torr, and control a processing environment temperature of the arc deposition to 125°C to 300°C, and control a voltage of the arc deposition to 500kV to 550kV, a current intensity being 400A to 430A, a current density being 106A/cm² to 1012A/cm², an arc voltage being 10V to 40V, an arc moving speed being 90m/s to 110m/s, and instantaneous discharging time being 10ns to 1000ns, and keeping for 200 seconds to 400 seconds; and
(H) completion of processing of ornament featuring high rigidity, low roughness, and a gold color simulating 18K gold color: using the color nitride ions 2, the first color metal ions 3, and the second color metal ions 4 to have surface rigidity controlled to 1800HV to 2000HV, roughness controlled to 0.01µm to 0.1µm, and LAB values of color parameters being L of 72 to 93, A of 2.5 to 8, and B of 15 to 35.

Thus, a main structure of an ornament surface processing treatment structure according to the present invention comprises:
a stainless-steel metallic base material 1;
a plurality of base-material cavity portions 11 formed in the stainless-steel metallic base material 1;
a plurality of color nitride ions 2 disposed in the base-material cavity portions 11 and on a surface of the stainless-steel metallic base material 1;
a plurality of first color metal ions 3 disposed on a surface of the color nitride ions 2; and
a plurality of second color metal ions 4 disposed on a surface of the first color metal ions 3, wherein the first color metal ions 3 and the second color metal ions 4 have same components, while having different purities and thicknesses due to controlled gas amount variation during processing.

The structure uses the color nitride ions 2, the first color metal ions 3, and the second color metal ions 4 to have surface rigidity controlled to 1800HV to 2000HV, roughness controlled to 0.01µm to 0.1µm, and LAB values of color parameters being L of 72 to 93, A of 2.5 to 8, and B of 15 to 35.

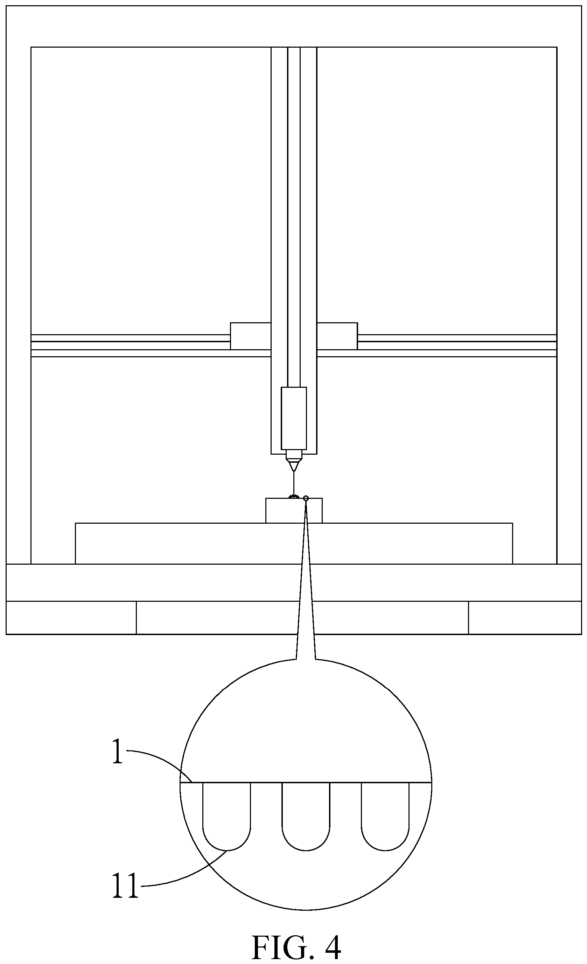

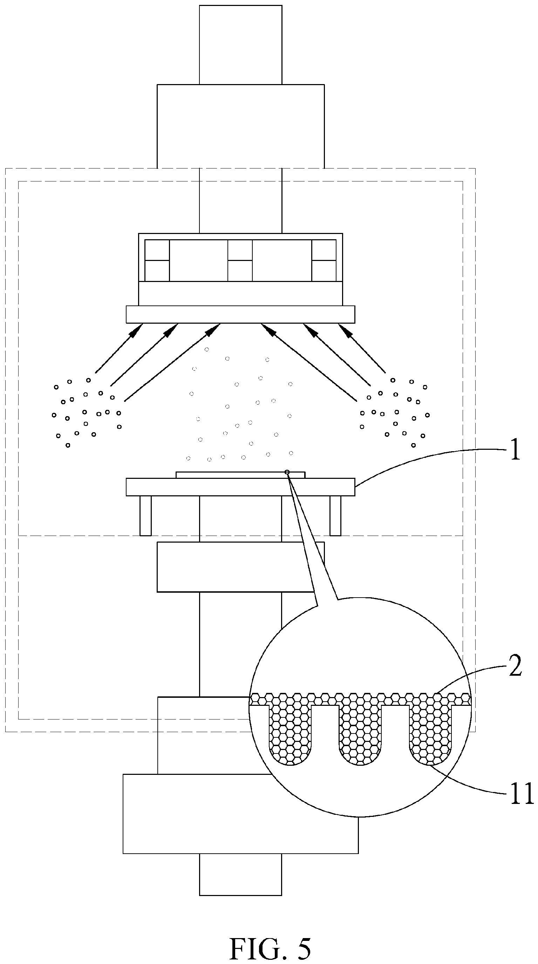

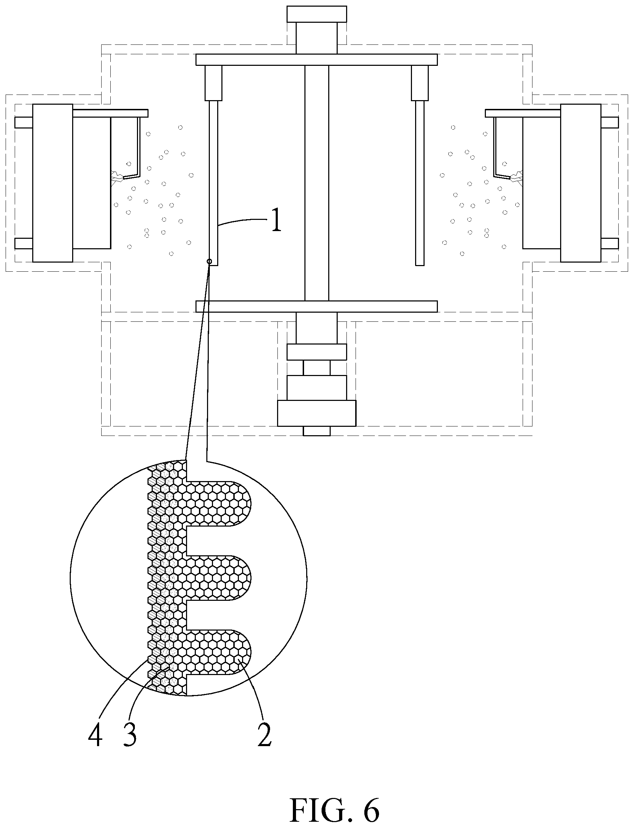

As shown in FIGS. 1-6, in processing, a stainless-steel metallic base material 1 is first selected. A piece of metal having an outer configuration "LOGO" is taken as an example in the instant embodiment. The raw material has a roughness level of 0.03µm to 0.2µm, and the LAB values of color parameters are L of 70 to 82, A of 0.3 to 0.5, and B of 4.0 to 7.2, and is generally a silver-gray color metal exhibiting particles that are perceivable by bare hands. The stainless-steel metallic base material 1 is subjected to ion bombardment, and processing parameters of the ion bombardment include: applying a gas pressure at a value of 0 Torr to -1 Torr to control an environment gas pressure to -1 Torr, an environment temperature of 200°C to 300°C, a voltage of 300kV to 400kV, an energy density of 106W/cm² to 109W/cm², a power density of 105W/cm² to 1011W/cm², and keeping for a time of 200 seconds to 400 seconds in order to remove oxides on the surface of the stainless-steel metallic base material 1 to expose a plurality of base-material cavity portions 11, so that except capillary pores (the base-material cavity portions 11) of the surface of the stainless-steel metallic base material 1, remaining portions of the surface all exhibit a smooth state to help reduce surface roughness to 0.01µm to 0.1µm in deposition processing subsequent thereto.

Next, the stainless-steel metallic base material 1 is then subjected to sputter deposition to implant color nitride ions 2 into the base-material cavity portions 11 and the surface of the stainless-steel metallic base material 1, wherein processing parameters of the sputter deposition include: applying a gas pressure at a value of 1 Torr to -1 Torr to control an environment gas pressure to -2 Torr, an environment temperature of 150°C to 400°C, a voltage of 350kV to 400kV and keeping for a time of 550 seconds to 1000 seconds, wherein the color nitride ions 2 are one of silicon nitride, aluminum nitride, and boron nitride, and the color nitride ions 2 comprise a composition of synthetic ceramics, in order to make color lighter to enhance color control and regulation in arc deposition processing and to increase the base material rigidity to 1800HV to 2000HV.

Finally, the stainless-steel metallic base material 1 is subjected to arc deposition to form first color metal ions 3 on a surface of the color nitride ions 2 and to form second color metal ions 4 on a surface of the first color metal ions 3, wherein processing parameters of the arc deposition include: applying a gas pressure at a value of 1 Torr to -1 Torr to control an environment gas pressure to -3 Torr, an environment temperature of 125°C to 300°C, a voltage of 500kV to 550kV, a current intensity of 400A to 430A, a current density of 106A/cm² to 1012A/cm², an arc voltage of 10V to 40V, an arc moving speed of 90m/s to 110m/s, an instantaneous discharging time of 10ns to 1000ns, and keeping for a time of 200 seconds to 400 seconds, wherein the first color metal ions 3 and the second color metal ions 4 are both a target material selected from one of nickel, chromium, zirconium, and titanium, and the first color metal ions 3 and the second color metal ions 4 are both not precious metal and have a low cost of purchase and they shows slightly red, blue, yellow, or gray color, and since the color of the color nitride ions 2 is close to white, it is possible to accurately generate a designated color through control of plasma, without being affect by the color of the base material, so as to help prevent waste of target material and avoid excessiveness of time for deposition, and based on the principle of light refraction, during the process of manufacturing, light refraction induced in the first color metal ions 3 and the second color metal ions 4 of the same material but different thicknesses is of a different degree from that of simply increasing one single layer, so that through color superimposition, in combination with influence caused by roughness, a desired color can be generated. In this invention, making LAB-value color parameters (L being 72 to 93, A being 2.5 to 8, B being 15 to 35) closest to 18K gold is desired. Further, since the ion bombardment processing has already made the surface smooth, influence of particles induced in the arc processing on the surface roughness can be reduced to the minimum.

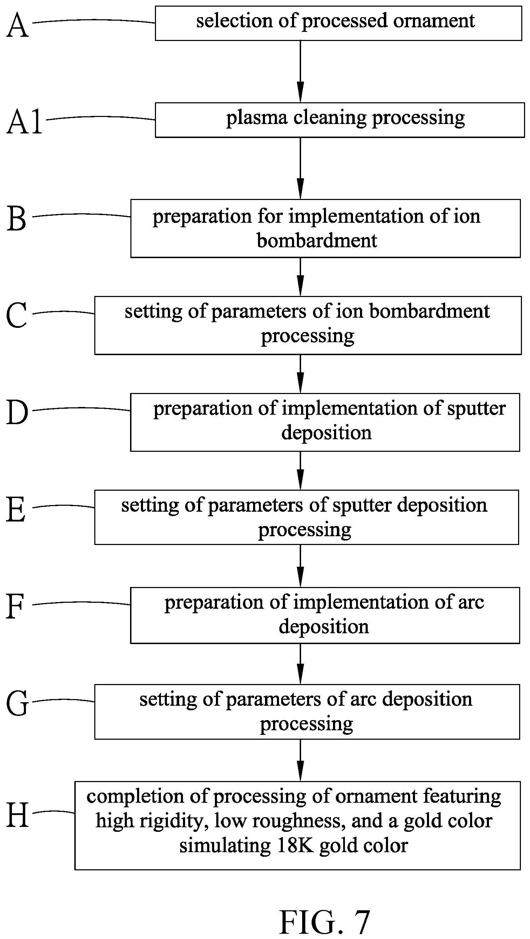

As shown in FIG. 7, the instant embodiment is generally similar to the previous embodiment but only different in requiring plasma cleaning processing be first conducted at a high temperature of 150°C to 250°C and a low pressure of 1.5 Torr to 2.5 Torr before the ion bombardment processing in order to clean the surface of the stainless-steel metallic base material. This operation may initially remove large particles attached to the surface of the stainless-steel metallic base material to have surface roughness reduced to 0.04µm to 0.1µm, so that loading induced in the ion bombardment processing that is implemented subsequently can be reduced to thereby lower down the cost of the ion bombardment processing and enhance performance of the ion bombardment processing. Specific steps of the instant embodiment are as follows:
(A) selection of processed ornament, (A1) plasma cleaning processing, (B) preparation for implementation of ion bombardment, (C) setting of parameters of ion bombardment, (D) preparation of implementation of sputter deposition, (E) setting of parameters of sputter deposition, (F) preparation of implementation of arc deposition, (G) setting of parameters of arc deposition, and (H) completion of processing of ornament featuring high rigidity, low roughness, and a gold color simulating 18K gold color.

## Claims

1. An ornament surface processing treatment method, of which main steps comprise:
(A) selecting a stainless-steel metallic base material (1);
(B) subjecting the stainless-steel metallic base material (1) to ion bombardment to remove oxides on a surface of the stainless-steel metallic base material (1) so as to expose a plurality of base-material cavity portions (11);
(C) applying a gas pressure at a value of 0 Torr to -1 Torr to control a processing environment gas pressure of the ion bombardment to -1 Torr and control a processing environment temperature of the ion bombardment to 200°C to 300°C, and a voltage of the ion bombardment to 300kV to 400kV, an energy density being 106W/cm² to 109W/cm², and a power density being 105W/cm² to 1011W/cm², and keeping for 200 seconds to 400 seconds;
(D) subjecting the stainless-steel metallic base material (1) to sputter deposition so as to implant color nitride ions (2) into the base-material cavity portions (11) and the surface of the stainless-steel metallic base material (1);
(E) applying a gas pressure at a value of 1 Torr to -1 Torr to control a processing environment gas pressure of the sputter deposition to -2 Torr, and control a processing environment temperature of the sputter deposition to 150°C to 400°C, and control a voltage of the sputter deposition to 350kV to 400kV, and keeping for 550 seconds to 1000 seconds;
(F) subjecting the stainless-steel metallic base material (1) to arc deposition so as to form first color metal ions (3) on a surface of the color nitride ions (2) and to further form second color metal ions (4) on a surface of the first color metal ions (3);
(G) applying a gas pressure at a value of 1 Torr to -1 Torr to control a processing environment gas pressure of the arc deposition to -3 Torr, and control a processing environment temperature of the arc deposition to 125°C to 300°C, and control a voltage of the arc deposition to 500kV to 550kV, a current intensity being 400A to 430A, a current density being 106A/cm² to 1012A/cm², an arc voltage being 10V to 40V, an arc moving speed being 90m/s to 110m/s, and instantaneous discharging time being 10ns to 1000ns, and keeping for 200 seconds to 400 seconds; and
(H) using the color nitride ions (2), the first color metal ions (3), and the second color metal ions (4) to have surface rigidity controlled to 1800HV to 2000HV, roughness controlled to 0.01 µm to 0.1µm, and LAB values of color parameters being L of 72 to 93, A of 2.5 to 8, and B of 15 to 35.

2. The ornament surface processing treatment method according to claim 1, wherein roughness of a raw material of the stainless-steel metallic base material (1) is 0.03µm to 0.2µm, and LAB values of color parameters are L of 70 to 82, A of 0.3 to 0.5, and B of 4.0 to 7.2.

3. The ornament surface processing treatment method according to claim 1, wherein Before Step (B), Step (A1) is first performed to subject the stainless-steel metallic base material (1) to plasma cleaning.

4. The ornament surface processing treatment method according to claim 3, wherein an operation temperature of the plasma cleaning is 150°C to 250°C and an operation pressure is 1.5 Torr to 2.5 Torr.

5. The ornament surface processing treatment method according to claim 1, wherein the color nitride ions (2) are selected from one of silicon nitride, aluminum nitride, and boron nitride.

6. The ornament surface processing treatment method according to claim 1, wherein the first color metal ions (3) and the second color metal ions (4) are selected from one of nickel, chromium, zirconium, and titanium.

7. An ornament surface processing treatment structure, which main comprises:
a stainless-steel metallic base material (1);
a plurality of base-material cavity portions (11) formed in the stainless-steel metallic base material (1);
a plurality of color nitride ions (2) disposed in the base-material cavity portions (11) and on a surface of the stainless-steel metallic base material (1);
a plurality of first color metal ions (3) disposed on a surface of the color nitride ions (2); and
a plurality of second color metal ions (4) disposed on a surface of the first color metal ions (3), wherein the color nitride ions (2), the first color metal ions (3), and the second color metal ions (4) are so used as to have surface rigidity controlled to 1800HV to 2000HV, roughness controlled to 0.01µm to 0.1µm, and LAB values of color parameters being L of 72 to 93, A of 2.5 to 8, and B of 15 to 35.

8. The ornament surface processing treatment structure according to claim 7, wherein roughness of a raw material of the stainless-steel metallic base material (1) is 0.03µm to 0.2µm, and LAB values of color parameters are L of 70 to 82, A of 0.3 to 0.5, and B of 4.0 to 7.2.

9. The ornament surface processing treatment structure according to claim 7, wherein the color nitride ions (2) are selected from one of silicon nitride, aluminum nitride, and boron nitride.

10. The ornament surface processing treatment structure according to claim 7, wherein the first color metal ions (3) and the second color metal ions (4) are selected from one of nickel, chromium, zirconium, and titanium.
